(19)
Europäisches
Patentamt
European
Patent Office
Office européen
des brevets

(11) **EP 3 640 367 A1**

(12) **EUROPEAN PATENT APPLICATION**

(43) Date of publication:
 **22.04.2020 Bulletin 2020/17**

(21) Application number: **18306376.7**

(22) Date of filing: **19.10.2018**

(51) Int Cl.:
 *C23C 18/12* [(2006.01)]    *C04B 41/00* [(2006.01)]
 *C30B 7/10* [(2006.01)]    *E04F 13/00* [(2006.01)]
 *C30B 29/16* [(2006.01)]

(84) Designated Contracting States:
 **AL AT BE BG CH CY CZ DE DK EE ES FI FR GB
 GR HR HU IE IS IT LI LT LU LV MC MK MT NL NO
 PL PT RO RS SE SI SK SM TR**
 Designated Extension States:
 **BA ME**
 Designated Validation States:
 **KH MA MD TN**

(71) Applicants:
 • **Université de Marne La Vallee
  77420 Champ Sur Marne (FR)**
 • **Institut Français des Sciences et Technologies
  des
  Transports, de l'Amenagement et des Reseaux
  77420 Champs sur Marne (FR)**

(72) Inventors:
 • **POUPART, Romain
  94000 CRETEIL (FR)**
 • **LEPRINCE, Yamin
  77164 FERRIERES EN BRIE (FR)**
 • **GNAMBODOE-CAPOCHICHI, Martine
  77420 Champs Sur Marne (FR)**

(74) Representative: **A.P.I. Conseil
 Immeuble Newton
 4 rue Jules Ferry
 64000 Pau (FR)**

(54) **ZNO NANOWIRES INTENDED FOR PHOTOCATALYSIS FOR WATER AND/OR AIR
 PURIFICATION**

(57)    The present invention concerns a method of a growth of ZnO nanowires (6b) intended for photocatalysis in water and/or air depollution, comprising the following steps:
- (i) cleaning a civil engineering element (1) having a volume (2) which presents external rough surfaces (4a, 4b, 4c, 4d) with asperities (3);
- (ii) immerging the civil engineering element (1) at least partially in a seed layer solution (5) which is an alcoholic solution with ions $Zn^{2+}$, with at least one given rough surface (4a) facing to the seed layer solution (5) for the impregnation of the given rough surface (4a) with asperities (3) by the seed layer solution (5);
- (iii) taking the immerged civil engineering element (1), out of the seed layer solution (5), with the seed layer (5a) coating the asperities (3) of the given rough surface (4a), without controlling the coating thickness of the seed layer (5a) on the given coated rough surface (4a);
- (iv) drying the given coated rough surface (4a);
- (v) annealing the seed layer coating of the given coated rough surface (4a) to obtain ZnO nanocristallites (6a);
- (vi) chemical bath deposition for direct growth of ZnO nanowires (6b) from the ZnO nanocristallites (6a) of the given coated rough surface of the civil engineering element.

Figure 4

**Description**

FIELD OF THE INVENTION

The invention concerns a method for ZnO nanowires Growth, the ZnO nanowires intended for photocatalysis for water and/or air depollution.

STATE OF ART

Since recent years, pollution of air and water is of major concerns in every urban center. Water pollution, either caused by industries, urban effluents or transportations affects biodiversity, human health and climate, among others. Thus, new solutions are needed for environmental treatments and purifications.

For such goal, photocatalysis processes monitored by UV light and then, sunlight, are envisaged. Photocatalysis process is a promising emerging solution for such aim, as it is a cheap and fast solution to degrade toxic organic compounds into harmless products ($CO_2$, $N_2$, $H_2O$, among others).

For the depollution of air and water, the majority of advanced work has used $TiO_2$ nanostructures as summarized in the thesis and the sheet "Technique of the Engineer" [1, 2]. During these last years, the use of ZnO nanostructures as photocatalysts for depollution water attracted more scientific community's attention as we could read about the review article in the specialized journal "Water Research" [3]. But the nanostructures used are classics made on laboratory substrates such as Silicon, glass, ...

Some publications exist on the ability of photocatalysis of ZnO-containing cement:

(1) the micro-powder mixture obtained from commercial ZnO and $TiO_2$ micro- / nano-powders of in cement [4];
(2) the composite obtained by the mixture of ZnO nano-needles (synthesized by co-precipitation method) in cement [5];
(3) application of a layer of ZnO nanoparticles on the cement surface [6].

In these 3 cases, organic pollutants such as blue methylene (BM), Rhodamine and Phenol were respectively used for photocatalysis tests.

SUMMARY OF THE INVENTION

Here, the invention presents a method of a growth of ZnO nanowires on civil engineering elements intended for photocatalysis for water and/or air depollution, comprising the following steps:

- (i) cleaning a civil engineering element having a volume which presents external rough surfaces with asperities, (especially to improve the wettability of the rough surfaces);
- (ii) immerging the civil engineering element (1) at least partially in a seed layer solution (5) which is an alcoholic solution with ions $Zn^{2+}$, with at least one given rough surface (4a) facing to the seed layer solution (5) for the impregnation of the given rough surface (4a) with asperities (3) by the seed layer solution (5);
- (iii) taking the immerged civil engineering element, out of the seed layer solution, without controlling the coating thickness on the given coated rough surface;
- (iv) drying the given coated rough surface;
- (v) annealing the seed layer coating of the given coated rough surface to obtain ZnO nanocristallites;
- (vi) chemical bath deposition for direct growth of ZnO nanowires from the ZnO nanocristallites of the given coated rough surface of the civil engineering element, by a growth solution which is an aqueous solution with ions $Zn^{2+}$, to obtain the civil engineering element with ZnO nanowires protruding on the given rough surface with asperities.

The civil engineer element coated with ZnO nanowires on its rough surfaces produced from the method of the invention can be integrated for instance in the development of the 5th-generation (5G) road, public garden, or in new building/house....

Smartly designed with new and possibly biobased materials, 5th generation plans to make smarter roads in the near future, which will be integrated numerous technologies including environment depollution function

Photocatalysis process is a promising emerging solution for such aim, as it is a cheap and fast solution to degrade toxic organic compounds into harmless products ($CO_2$, $N_2$, $H_2O$, among others). With the invention, the photocatalysis process can be incorporated into our everyday life. Thus, incorporating metal oxide semiconductor (photocatalyst) onto civil engineering materials is a smart way to achieve this goal, as they are known to perform photocatalysis under ultraviolet lighting, even under visible lighting with doped photocatalyst.

BRIEF DESCRIPTION OF THE DRAWINGS

Other advantages and characteristics of the disclosed devices and methods will become apparent from reading the description, illustrated by the following figures, where:

Figure 1: Top and side views of two different pavement (Left: Grey sample -Tile & Right: Red sample -Concrete)
A) before, B) after the growth of ZnO nanostructures and C) after the growth of Fe-doped (3 mol%) ZnO nanostructures.

Figure 2: SEM images showing A) Random distributed ZnO nanorods at the surface of Red sample and B) Fe-doped flower-like ZnO nanostructure at the surface of modified Red samples. Inset: zoom of the flower-like nanostructures Figure 2C: SEM images showing ZnO nanorods at the surface on the tile

Figure 3: UV-Visible spectra of the sample's surfaces: A) ZnO-decorated Red sample and B) Fe-doped ZnO-decorated Red sample.

Figure 4: Sketch of ZnO nanostructures grown process on rough surface including the new method for seed layer deposition on the non-conventional substrate.

Figure 4a: detail of the growth

Figure 5: UV-Visible investigation of different dyes photodegradation using Red samples as photocatalysts: methylene blue (MB), methyl orange (MO) and acid red 14 (AR14). With A), C) and E) the different UV-Visible spectra recorded during photodegradation process showing the pollutant characteristic absorption peak decreases with the UV irradiation time and B), D) and F) the different plot of the degradation rate (X) in the function of the time for MB, MO and AR14, respectively.

Figure 6: UV-Visible investigation of MO photodegradation by Iron-doped Red sample. With A) UV-Vis spectra recorded during photocatalysis process for Fe-doped Red sample B) the plot of the degradation rate (X) in function of the time for Fe-doped Red sample showing an improvement of photocatalytic efficiency.

DETAILED DESCRIPTION

The present invention concerns a method for ZnO nanowires 6b Growth Directly onto civil engineering element 1 having a volume with external rough surfaces 4 which present asperities 3, the ZnO nanowires being able to realize the photocatalysis for water and/or air depollution.
The expression "civil engineering element 1" means solid element used in construction, and for civil engineering (road, house, building ...). The element can be porous, non-homogenous, large in size.... The expression "civil engineering materials" or "construction element" can be used too.
The word 'asperities' represents all the relief of the external surface (projecting and recessed parts of the civil engineering element 1).
The civil engineering element used for construction or other applications of everyday life, serves here in the present invention a substrate for the growth of the ZnO nanowires which realizes the photocatalysis for water and/or air depollution.

The method comprises the following steps:

- (i) cleaning a civil engineering element 1 having a volume 2 which presents external rough surfaces 4a, 4b, 4c, 4d with asperities 3, to improve the wettability of the rough surfaces 4a, 4b, 4c, 4d;
- (ii) immerging (displacing) at least partially the civil engineering element 1 in a seed layer solution 5 which is an alcoholic solution with ions $Zn^{2+}$ with at least one given rough surface 4a facing to the seed layer solution 5, and impregnation of the given rough surface 4a by the seed layer solution 5;
- (iii) taking the immerged civil engineering element 1, out of the seed layer solution 5, with the seed layer 5a coating the asperities 3 of the given rough surface 4a, without controlling the coating thickness of the seed layer 5a on the given coated rough surface 4a;
- (iv) drying the given rough surface 4a;
- (v) annealing the seed layer coating of the coated rough surface 4a to obtain ZnO nanocristallites 6a;
- (vi) chemical bath deposition for direct growth of ZnO nanowires 6b from the ZnO nanocristallites 6a of the given coated rough surface of the civil engineering element 1, by a growth solution which is an aqueous solution with ions $Zn^{2+}$, to obtain the civil engineering element 1 with ZnO nanowires 6b protruding on the given rough surface 4a.

In one embodiment, the chemical bath deposition is a hydrothermal growth.
In other embodiment, the chemical bath deposition can be sol-gel method.
In the step (i), the civil engineering element 1 is cleaned using a mixture of deionized water with a drop of surfactant under ultrasonic agitation to remove any dusts and impurities adsorbed onto the surface, followed by a rinsing with deionized water and ethanol.
In the step (ii), the length of the civil engineering element 1 is maintained horizontally during the vertical displacement of the civil engineering element 1 in the seed layer solution 5. The principal rough surface 4a to coat extends along the length, and is horizontal in the seed layer solution 5. It is a difference with the spin-coating.
In the step (ii), several rough surfaces 4a, 4b, 4c, 4d are impregnated by the seed layer, and the steps (iii), (iv), (v), (vi) are realized for these rough surfaces 4a, 4b, 4c, 4d. All the rough surfaces 4 can thus be coated with ZnO nanowires 6b which protrude.
The step (ii) can be realized manually or automatically. The control of the speed of the exit of the civil engineering element 1 out of the seed layer solution 5 has no importance.
For the immersion (vertical displacement) in the seed layer solution 5, the civil engineering element 1 can be taken:

- manually by the fingers to plunge it into the solution;

- automatically by the arms of a robot.

The civil engineering element 1 can be taken on its sides, the top or the bottom.

The seed layer solution 5 used can be a buffer solution of $Zn(Ac)_2$ in absolute ethanol.

Advantageously, the step (ii) is quick, and lasts a time inferior to 5 seconds. It is a difference with the spin-coating.

In the steps (ii) and (iii), the seed layer 5a enters in the asperities 3 of the given rough surface 4a and forms the coating of the given rough surface 4a.

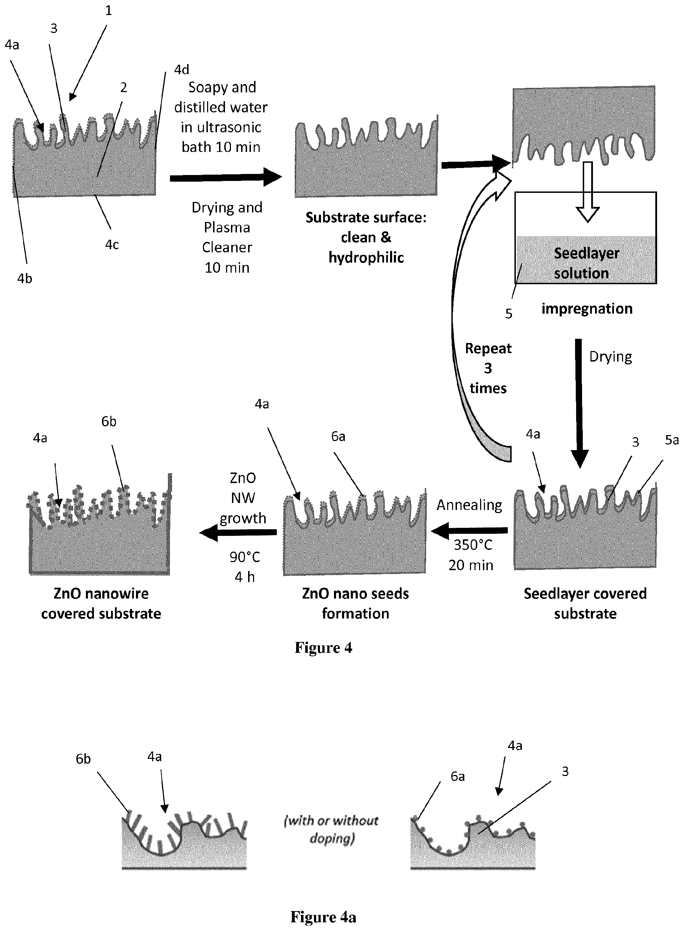

In the step (iii), the civil engineering element 1 can be displaced (turned back , for instance pivotated) so as to expose the given rough surface 4a to the drying air. Here on figure 4 the given rough surface 4a is upwards (opposite to the plane surface of the seedlayer solution), in horizontal position. The seed layer 5a enters in the asperities 3 of the given rough surface 4a and forms the coating of the given rough surface 4a.

Then, the air drying, for instance a blow drying, is realized in the step (iv).

The steps (ii), (iii) and (iv) are repeated to render the seed layer covering the entire rough surface (all the asperities 3). They can be repeated each between three and five times according to the surface toughness.

In the step (v), a thermal annealing is realized between 300-370°C during 15-25 minutes.

In the step (vi), the hydrothermally-driven growth of ZnO nanowires 6b are realized into an aqueous mixture of methenamine and of $Zn(NO_3)_2$ between 80-95°C during 2-4 hours.

In the step (vi), x mol% of another metal like Fe or Ag were added to the growth solution for improving photocatalysis effect, x being inferior or equal to 5%.

For instance, 3 mol% $FeCl_3$ were added to the growth solution for improving photocatalysis effect.

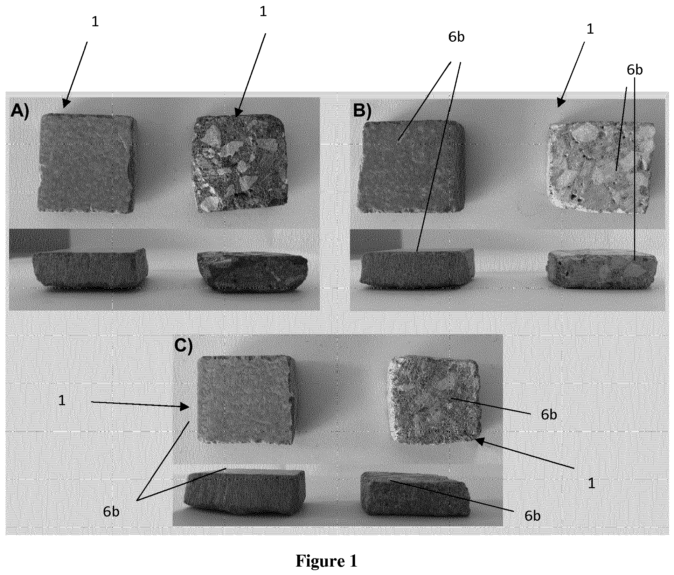

The present invention also relates to a civil engineering element 1 with ZnO nanowires 6b realized by the method as previously described and as represented on figure 1.

The civil engineering element 1 can have a length of the rough surface superior to 5 cm. The size of the substrates can vary according to the needs: 10 cm block, or 50 cm concrete / stone block, it is enough to adapt the size of the container which contains the growth solution.

For instance, the civil engineering element 1 is a pavement, a block or a slab.

For instance, the civil engineering element 1 element is in cement, stone, floor tile.

The bandgap energy of ZnO nanowires 6b grown on the rough surface for the photocatalysis is between 3.0-3.2 eV for doped ZnO nanowires 6b, whereas the bandgap energy is 3.3 eV for undoped ZnO nanowires 6b.

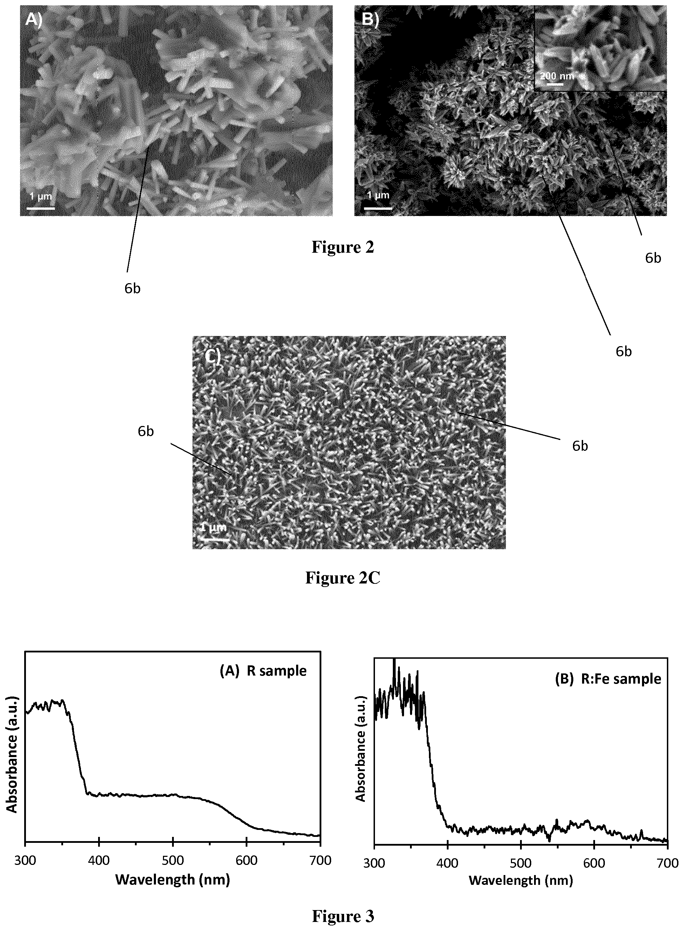

The ZnO nanowires 6b can have the hexagonal crystalline structure with a preferential growth direction along the *c*-axis in the crystal system, as represented on figure 2.

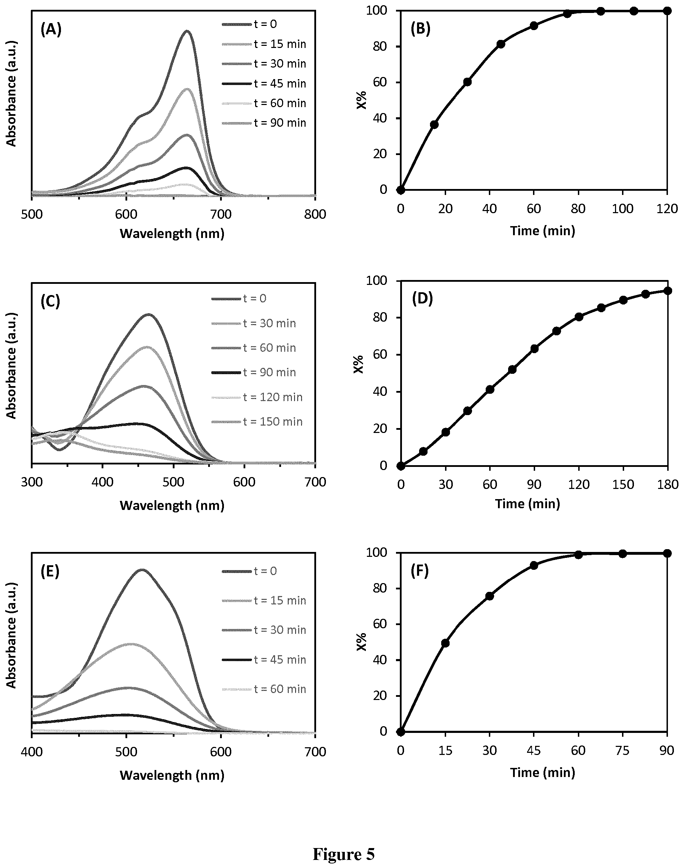

The present invention also relates to a use of the civil engineering element 1 in photocatalysis for water and air depollution, with ZnO nanowires 6b protruding on the given rough surfaces 4a, 4b, 4c, 4d, and as described on figures 5-6.

The invention also relates to a construction with several civil engineering elements 1 according to the invention.

**ONE EMBODIMENT ZnO Nanowires Growth Directly Onto Civil Engineering or Construction Materials: Smart Materials for Supported Photodegradation**

**1. Experimental details**

Red concrete pavements with initial dimension of 10 x 10 x 8 cm (noted as sample R) were used as elements, and subsequently cut into pieces of around 2.5 x 2.5 x 0.7 cm, (Figure 1A). Prior to any synthesis, each sample of concrete was washed using DI water with a drop of surfactant under ultrasonic agitation during 15 minutes to remove any dusts and impurities adsorbed onto the sample surface, followed by a rinsing with pure DI water and a drying with air flow.

Following this preparation, ZnO nanowires 6b (NWs) were grown onto our civil engineering samples by a two-step hydrothermal method, slightly adapted from our previous works. Due to the very rough surface nature of civil engineering materials, we use a new seed layer deposition method, because the classical spin-coating process usually employed for seed layer deposition on smooth surface, such as Si wafer or glass, is not suitable for this kind of substrates. Indeed, due to the huge surface roughness, the coating deposition would not be perfectly homogeneous on such materials. To avoid that, a simple horizontal impregnation with an alcoholic solution was implemented.

Firstly, samples R were impregnated with a buffer solution (C = 0.01 M) of $Zn(Ac)_2 \cdot 2H_2O$ in absolute ethanol (99.9%) during 5 minutes, followed by a thermal annealing at 350°C during 20 minutes.

Then, the second step consisted in the hydrothermally-driven growth of ZnO NWs where samples were put into an aqueous mixture of 0.05 M of methenamine (HMTA) and 0.05 M of $Zn(NO_3)_2 \cdot 2H_2O$ at 90°C during 4 h.

After that, they were subsequently characterized by UV-Visible spectroscopy at their surfaces and by field-emission scanning electron microscopy (FE-SEM) in order to determine the gap of Red samples and to investigate the structure present at the samples surface, respectively.

In order to enhance the photocatalytic activity of our materials, Fe-doping was considered. The protocol used was the same as described earlier in this paper except 3 mol% of $FeCl_3$ were added to the growth solution.

Following the preparation of our different doped and undoped samples, we decided to investigate the potential applications for photodegradations of organic model molecules used in pharmaceutical and/or textile industry. Three dyes were selected, acid red 14 (AR14), methylene blue (MB) and methyl orange (MO), and were prepared a aqueous solution of concentration fixed at 10 μM for each dye. ZnO-decorated Red samples were immersed into 30 mL of this solution and irradiated with an UV lamp (4500 mW/cm$^2$, λ = 365 nm) under magnetic stirring. The distance between the UV source and the sample was maintained at 10 cm. After reaction, both samples (undoped and Fe-doped) were washed several times with DI water in order to remove any adsorbed dyes. Iron-doped ZnO-decorated materials were only tested with MO, one of the most difficult to degrade organic dyes.

The as-described photocatalysis has been monitored by UV-Visible spectrophotometry and followed every 15 minutes. The residual dye content has been determined by degradation efficiency defined as X (Equation 1):

$$\text{Equation 1: } X(\%) = \frac{A_0 - A}{A_0} \times 100$$

where $A_0$ and A stands for the initial and actual absorption peak value, at the wavelength of the dye maximum absorption (i.e. $\lambda_{max}$ = 665 nm for MB; 464 nm for MO and 515 nm for AR, respectively), respectively.

Finally, to check the competition between degradation and adsorption, R tests samples were put directly into 30 mL of each solution (MO, AR or MB) without any UV irradiation. After 3 hours, the samples were removed and thoroughly washed with DI water. UV-Visible spectra were recorded prior and after Red samples immersion. The adsorption (in %) was determined using Equation 1.

## 2. Result and Discussions

### *Synthesis and growth of ZnO nanowires*

As we discussed earlier in this report, the inventors used a previously described protocol using Zn(Ac)$_2$ dissolved into ethanol to synthetize and grow our ZnO NWs directly onto commercial materials, due to this process being easy to reproduce. It is worth mentioning that the short time (20 min) in a furnace should not affect the mechanical properties of Red samples, as concrete properties are not really impacted by temperature lower than 400°C.

Figure 1A and 1B show one example sample before and after the ZnO NWs growth, respectively, where we can note that the sample appearance has been slightly changed in colour with a more whitish, due to their surface being covered by a ZnO NWs layer. The microstructure of the as-grown ZnO NWs on those elements has been examined by SEM observation.

As depicted in Figure 2A, for ZnO-decorated Red samples, the extremely rough and porous offer also a quite suitable element for the ZnO NWs growth as well as increasing the specific area for the nucleation sites (Figure 4). However, the structures obtained are quite different from the pendant ones obtained from a model surface like Si-wafer (i.e. ZnO nanowires 6b) with structures looking more like nanorods. These various heterogeneities in shapes, sizes and orientations of the ZnO structures could leads to reflection signals, as seen in the UV-Vis spectra signals (Figure 3A). However, the ZnO band gap value could be measured with the Tauc-Lorentz model and proved to be around 3.30 eV, demonstrating that these materials enables us to perform photocatalysis under UV irradiation.

Concerning the iron-doped Red samples (Figure 1C), differences can be observed in the obtained morphologies, as well as in the gap measured. First, macroscopically, the R elements presents a yellowish coloration rather than the distinguished white tone of the pure ZnO sample. Secondly, they exhibits different morphologies growing onto its surface.

As we can observe in the Figures 2B, flower-like microstructure can be observed. The dendritic structure brought by the flower structures also increases the specific area and, combined with the porous surface, could lead to a better efficiency. Compared to reference element like Si-wafer described in the literature, the nanostructures obtained are completely different. Concerning their optical properties, they exhibited a gap of about 3.20 eV, as calculated from the Tauc-Lorentz model from Figure 3B. The band-gap energy seems to decrease in the Fe-doped ZnO samples, which is the aim of such doping.

This diminution in the band-gap value leads to an extent of the light absorbance in the visible range, thus to improve the photocatalysis efficiency.

### *Photocatalysis of dyes*

ZnO is well known to promote the UV photodegradation of organic compounds. Organic dyes are model molecules in such reaction and, in this work, we investigated three different dyes: MB, which is a thiazine, and MO and AR, which are diazo compounds. The initial concentration of each aqueous solution was fixed at 10 μM with a fixed volume of 30 mL, in which a ZnO-decorated sample was immersed. The distance between the UV lamp and the dye solution was fixed at 10 cm for all measurements. The characteristic adsorption peaks corresponding to MB, MO and AR molecules were determined at 665, 464 and 515 nm, respectively. The absorbance used for the calculus of the degradation efficiency (X) will logically be the one measured at those different wavelengths for the corresponding dye. As described in a previous work, these three dyes decompose mainly into less harmful products like $CO_2$, $H_2O$, $NO_3^-$ or $SO_4^{2-}$ in the mineralization process.

Figure 5 shows the UV-Visible spectra recorded for the degradation of MB, MO and AR with Red samples. Results show a total degradation in 90 min for MB and in 60 min for AR14. In the case of MO, degradation rate was not exceeding 92% after 3 hours of reactions. Furthermore, pavement samples showed quasi no losses in efficiency in a second run with the same sample.

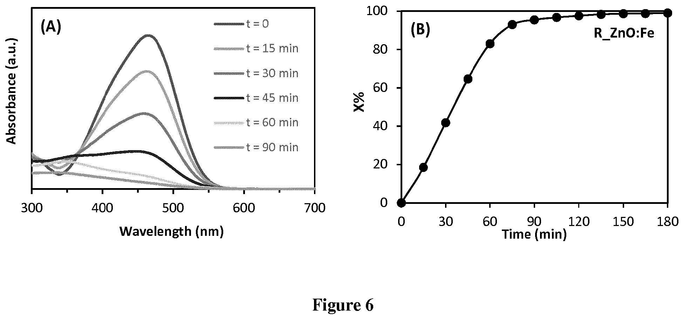

Iron-doped Red samples shows a higher efficiency than undoped Red samples with almost total degradation effectively reached in 2 hours (Figure 6).

## 3. Conclusion

In this study, we have described the first known hydrothermally-mediated growth of ZnO nanostructures onto civil engineering materials.

The energy-saving process used enabled us to create structures with gap around 3.25-3.30 eV, allowing us to perform the successful photodegradation of three different common dyes, with excellent reusability and better results than literature-based reference samples from silicon wafer.

Such supported structures, easy to implement onto commercially available materials, could be used simply into everyday life devices to promote depollution. Iron-doping was also implemented to check the viability of such process and, again, a higher efficiency than reference elements is demonstrated.

## References

[1] D.A. Cazoir, « Traitement d'eaux huileuse par photocatalyse heterogene : application a la dépollution des eaux de cales », These, Université Claude Bernard Lyon 1, 2011.

[2] D. Schaming et al. « Photocatalyse : des matériaux nanostructures aux réacteurs photocatalytiques », Technique de l'Ingénieur, Réf. : NM3600, Date de publication : 10 août 2017.

[3] Chen et al. « Preparation of ZnO Photocatalyst for the Efficient and Rapid Photocatalytic Degradation of Azo Dyes », Nanoscale Research Letters 12 (2017) 143-152.

[4] L. Sneff et al. « The influence of TiO2 and ZnO powder mixtures on photocatalytic activity and rheological behavior of cement pastes », Construction and Building Materials 65 (2014) 191-200.

[5] V.P. Singh et al. « Photocatalytic, hydrophobic and antimicrobial characteristics of ZnO nano needle embedded cement composites », Construction and Building Materials 158 (2018) 285-294.

[6] H.Z. Malayeri et al. « Photocatalytic phenol degradation by immobilized nano ZnO: intermediates & key operating parameters », Water Environ Res. 86 (2014) 771-778.

## Claims

1. Method of a growth of ZnO nanowires (6b) intended for photocatalysis in water and/or air depollution, comprising the following steps:

   - (i) cleaning a civil engineering element (1) having a volume (2) which presents external rough surfaces (4a, 4b, 4c, 4d) with asperities (3);
   - (ii) immerging the civil engineering element (1) at least partially in a seed layer solution (5) which is an alcoholic solution with ions $Zn^{2+}$, with at least one given rough surface (4a) facing to the seed layer solution (5) for the impregnation of the given rough surface (4a) with asperities (3) by the seed layer solution (5);
   - (iii) taking the immerged civil engineering element (1), out of the seed layer solution (5), with the seed layer (5a) coating the asperities (3) of the given rough surface (4a), without controlling the coating thickness of the seed layer (5a) on the given coated rough surface (4a);
   - (iv) drying the given coated rough surface (4a);
   - (v) annealing the seed layer coating of the given coated rough surface (4a) to obtain ZnO nanocristallites (6a);
   - (vi) chemical bath deposition for direct growth of ZnO nanowires (6b) from the ZnO nanocristallites (6a) of the given coated rough surface of the civil engineering element (1), by a growth solution which is an aqueous solution with ions $Zn^{2+}$, to obtain the civil engineering element (1) with ZnO nanowires (6b) protruding on the given rough surface (4a).

2. Method according to claim 1, wherein the chemical bath deposition is a hydrothermal growth.

3. Method according to claims 1-2, wherein in the step (iii), after the exit of the civil engineering element (1) out of the seed layer solution (5), the civil engineering element (1) is turned back so that the given coated rough surface (4a) is upwards.

4. Method according to claims 1-3, wherein the steps (ii), (iii) and (iv) are repeated so that the seed layer (5a) covers the entire given coated rough surface (4a).

5. Method according to claim 4, wherein the steps (ii), (iii) and (iv) are repeated between three and five times.

6. Method according to claims 1-5, wherein in the step (ii), the length of the civil engineering element (1) is maintained horizontally during the vertical displacement of the civil engineering element (1) in the seed layer solution (5), and the given rough surface (4a) to coat extends along the length.

7.  Method according to claims 1-6, wherein in the step (ii), several rough surfaces (4a, 4b, 4c, 4d) are impregnated by the seed layer, and the steps (iii), (iv), (v), (vi) are realized for these rough surfaces (4a, 4b, 4c, 4d).

8.  Method according to claims 1-7, wherein the step (ii) lasts a time inferior to 5 seconds.

9.  Method according to claims 1-8, wherein:

    - the civil engineering element (1) is a pavement, a block or a slab;
    - the material of the civil engineering element (1) is: concrete, cement, stone, or floor tile.

10. Method according to claims 1- 9, wherein in the step (ii) the seed layer solution (5) is a buffer solution of $Zn(Ac)_2$ in absolute ethanol.

11. Method according to claims 1- 10, wherein in the step (i) the civil engineering element (1) is cleaned using a mixture of deionized water with a drop of surfactant under ultrasonic agitation to remove any dusts and impurities adsorbed onto the surface, followed by a rinsing with deionized water and ethanol.

12. Method according to claims 1- 11, wherein in the step (v) a thermal annealing is realized between 300°C - 370°C during 15-25 minutes and in the step (vi) the hydrothermally-driven growth of ZnO nanowires (6b) are realized into an aqueous mixture of methenamine and of $Zn(NO_3)_2$ between 80-95 °C during 2-4 h.

13. Method according to claims 1- 12, wherein in the step (vi) x mol% of another metal like Fe or Ag were added to the growth solution for improving photocatalysis effect, x being inferior or equal to 5%.

14. Civil engineering element (1) with ZnO nanowires (6b) on their rough surface(s) (4a, 4b, 4c, 4d) realized by the method according to claims 1-13.

15. Civil engineering element (1) according to claim 14, wherein the civil engineering element (1):

    - is a pavement, a block or a slab, and
    - is in cement, stone, or floor tile.

16. Civil engineering element (1) according to claims 14-15, wherein the ZnO nanowires (6b) own the hexagonal crystalline structure.

17. Civil engineering element (1) according to claims 14-16, wherein the length of the rough surface of the civil engineering element (1) is superior to 5 cm.

18. Construction with several civil engineering elements (1) according to claims 14-17.

**Figure 1**

Figure 2

Figure 2C

Figure 3

**Figure 4**

**Figure 4a**

Figure 5

**Figure 6**

| | Europäisches Patentamt European Patent Office Office européen des brevets | EUROPEAN SEARCH REPORT | Application Number EP 18 30 6376 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 108 505 699 A (SHENZHEN MINGCHUANG AUTOMATIC CONTROL TECH CO LTD) 7 September 2018 (2018-09-07) | 1-3,6-8, 10-12, 14,16 | INV. C23C18/12 C04B41/00 C30B7/10 E04F13/00 C30B29/16 |
| Y | * paragraph [0004]; figure 1 * * paragraph [0009] * * paragraph [0019] * * paragraph [0039] - paragraph [0044] * | 9,13,15 | |
| X | CN 104 692 671 A (UNIV TIANJIN CHENGJIAN) 10 June 2015 (2015-06-10) | 1-8,12, 14,17,18 | |
| Y | * abstract * * paragraph [0006] * * paragraph [0013] - paragraph [0018] * | 9,13,15 | |
| Y | GB 2 425 075 A (MARLEY ETERNIT LTD [GB]) 18 October 2006 (2006-10-18) * page 1, lines 5-7 * * page 2, lines 3-5 * * page 3, lines 5-10 * * page 3, lines 24-32 * | 9,15 | |
| Y | YAMINA HABBA ET AL: "Enhanced Photocatalytic Activity of Iron-Doped ZnO Nanowires for Water Purification", APPLIED SCIENCES, vol. 7, no. 11, 17 November 2017 (2017-11-17), page 1185, XP055565085, DOI: 10.3390/app7111185 * abstract; figures 1, 2 * * Item 2, first paragraph * | 13 | TECHNICAL FIELDS SEARCHED (IPC) C23C C04B C30B E04F |

-/--

The present search report has been drawn up for all claims

| Place of search | Date of completion of the search | Examiner |
|---|---|---|
| The Hague | 27 March 2019 | Telias, Gabriela |

EPO FORM 1503 03.82 (P04C01)

page 1 of 2

Europäisches
Patentamt

European
Patent Office

Office européen
des brevets

# EUROPEAN SEARCH REPORT

Application Number

EP 18 30 6376

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | MARTO J ET AL: "Photocatalytic decolouration of Orange II by ZnO active layers screen-printed on ceramic tiles", JOURNAL OF HAZARDOUS MATERIALS, ELSEVIER, AMSTERDAM, NL, vol. 163, no. 1, 15 April 2009 (2009-04-15), pages 36-42, XP025880385, ISSN: 0304-3894, DOI: 10.1016/J.JHAZMAT.2008.06.056 [retrieved on 2008-06-22] * Introduction and experimental procedure * ----- | 9,15 | |

TECHNICAL FIELDS
SEARCHED      (IPC)

The present search report has been drawn up for all claims

| Place of search | Date of completion of the search | Examiner |
|---|---|---|
| The Hague | 27 March 2019 | Telias, Gabriela |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 30 6376

This annex lists the patent family members relating to the patent documents cited in the above-mentioned European search report.
The members are as contained in the European Patent Office EDP file on
The European Patent Office is in no way liable for these particulars which are merely given for the purpose of information.

27-03-2019

| Patent document cited in search report | | Publication date | Patent family member(s) | Publication date |
|---|---|---|---|---|
| CN 108505699 | A | 07-09-2018 | NONE | |
| CN 104692671 | A | 10-06-2015 | NONE | |
| GB 2425075 | A | 18-10-2006 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Traitement d'eaux huileuse par photocatalyse heterogene : application a la dépollution des eaux de cales. **D.A. CAZOIR.** These. Université Claude Bernard Lyon, 2011, vol. 1
- **D. SCHAMING et al.** Photocatalyse : des matériaux nanostructures aux réacteurs photocatalytiques. *Technique de l'Ingénieur, Réf. : NM3600,* 10 August 2017
- **CHEN et al.** Preparation of ZnO Photocatalyst for the Efficient and Rapid Photocatalytic Degradation of Azo Dyes. *Nanoscale Research Letters,* 2017, vol. 12, 143-152

- **L. SNEFF et al.** The influence of TiO2 and ZnO powder mixtures on photocatalytic activity and rheological behavior of cement pastes. *Construction and Building Materials,* 2014, vol. 65, 191-200
- **V.P. SINGH et al.** Photocatalytic, hydrophobic and antimicrobial characteristics of ZnO nano needle embedded cement composites. *Construction and Building Materials,* 2018, vol. 158, 285-294
- **H.Z. MALAYERI et al.** Photocatalytic phenol degradation by immobilized nano ZnO: intermediates & key operating parameters. *Water Environ Res.,* 2014, vol. 86, 771-778